# EUROPEAN PATENT SPECIFICATION

(11) **EP 2 448 383 B1**
(45) Date of publication and mention of the grant of the patent: **11.09.2013**
(21) Application number: 10425349.7
(22) Date of filing: 11.11.2010
(51) Int. Cl.: H05K 3/10, H05K 1/03

(54) **Process for producing conductive and/or piezoresistive traces on a polymeric substrate**
Verfahren zur Herstellung leitfähiger und/oder piezoresistiver Spuren auf einem Polymersubstrat
Procédé de fabrication de pistes conductrices et/ou piézorésistives sur un substrat polymère

(30) Priority: 26.10.2010 EP 10425339
(43) Date of publication of application: 02.05.2012
(73) Proprietor: C.R.F. SOCIETÀ CONSORTILE PER AZIONI, 10043 Orbassano (TO) (IT); R.T.M. S.p.A. - Istituto per le Ricerche di Tecnologia Meccanica e l'Automazione S.p.A., 10011 Aglie' (TO) (IT)
(72) Inventor: Zecchina, Adriano, 10126 Torino (IT); Bardelli, Fabrizio, 10125 Torino (IT); Bertarione, Serena, 10020 Baldissero Torinese (Torino) (IT); Caputo, Giuseppe, 10125 Torino (IT); Castelli, Paolo, 10011 Aglié (Torino) (IT); Cesano, Federico, 10091 Alpignano (Torino) (IT); Civera, Pierluigi, 10023 Chieri (Torino) (IT); Demarchi, Danilo, 12037 Saluzzo (Cuneo) (IT); Galli, Roberta, 10011 Aglié (Torino) (IT); Innocenti, Gianfranco, 10043 Orbassano (Torino) (IT); Scarano, Domenica, 10141 Torino (IT); Veca, Antonino, 10043 Orbassano (Torino) (IT); Zanetti, Marco, 10023 Chieri (Torino) (IT)
(74) Representative: Rambelli, Paolo

(56) References cited:
- DE-A1-102008 048 459
- US-A1- 2006 250 781
- US-A1- 2008 004 381
- US-B1- 6 762 073

## Description

The present invention refers to a process for producing electrically conductive and/or piezoresistive traces on a polymeric substrate by using a laser beam.

A laser process for writing conductive traces on a polymeric substrate is described in EP 0 230 128 A and in WO0223962 A. The resulting traces comprise electrically conductive carbon, produced by the thermal decomposition of the surface material of the substrate following localised laser heating. The materials able to be used as substrate are polymeric materials susceptible to carbonisation, like for example phenyl-formaldehyde resins, polyimides, polymers of furfuryl alcohol, or any other polymer susceptible to decomposing to produce high carbonisation yields; the polymeric substrates can also comprise dispersed charges that improve the absorption of light at the laser wavelength, like for example, carbon, talc, cotton or wood flour.

DE 10 2008 048 459 A1 describes a process according to the preamble of claim 1, applied to a composite material which includes carbon nanotubes and wherein conductive traces are obtained by thermal treatment including laser irradiation.

US 6 762 073 B1 describes a method of fabricating an electronic interconnect device comprising the steps of combining an insulating dielectric material, a fibrous reinforcing material and a conducting material, wherein the conducting material comprises carbon nanotubes and selectively exposing the conducting material in the composite substrate material to electromagnetic radiation to render portions of the carbon nanotubes non conducting.

US 2008/004381 describes a polymer blend composed of polypropylene and/or polypropylene copolymer and another polymer which is incompatible with the polypropylene and/or the polypropylene copolymer, further including a modified montmorillonite a filler.

The purpose of the present invention is to provide a process suitable for allowing the production of electrically conductive traces on polymeric substrates that do not constitute a substrate suitable for carbonisation ("*non char forming polymers*").

Another purpose of the invention is to provide a process that allows the production of conductive and/or piezoresistive traces in polymers widely used in vehicles and domestic appliances, like for example polypropylene and polyethylene.

In view of such purposes, the object of the invention is a process as defined in the attached claims, which constitute an integral part of the present specification.

The invention considers the use of composite polymeric substrates, comprising a polymeric matrix filled with a dispersed phase comprising a carbonisation promoter; thanks to the presence of the carbonisation promoter, the pyrolysis mechanism of the polymer, caused by the laser ablation, is directed towards the formation of conductive carbonaceous structures, at the expense of volatilization. The additive added to the polymeric polymeric matrix as promoter, upon mixing, can participate in conduction, thickening at the trace.

As carbonisation promoters filamentary nanostructures are used selected among carbon nanofibres (CNFs), carbon nanotubes (CNTs) of the single walled (SWCNTs) and multiwalled (MWCNTs) type, as such and/or functionalised and carbon nanotubes in which some atoms ofN substitute the carbon, (carbon nitride nanotubes or CNNTs).

The carbon nanotubes and nanofibres used in the invention are filamentary structures consisting of "carbon layers" that are more or less crystalline and ordered, stacked and/or rolled. A sufficiently rigorous classification of nanofibres and of the types of carbon nanotubes is the following, although it is common to consider all of the carbon structures elongated along a prevalent direction of growth with an inner cavity to form a "tube", as carbon nanotubes. The most rigorous classification requires the definition of "graphenic layer", by which we mean a sheet consisting of carbon atoms C-sp² that are ordered and organised in a planar fashion with a honeycomb structure (to form hexagons). Structurally speaking, the graphite consists of single graphenic layers stacked one on top of the other to form crystals.

According to this more rigorous definition, the carbon nanotubes (CNTs) have the graphenic layers summarily arranged parallel to the filament so as to constitute a "nanotube", more or less hollow on the inside and with parallel and rolled up walls. On the other hand, the carbon nanofibres (CNFs) are all the structures, more or less ordered, the planes of which when in order are stacked, or form walls that can consist of graphenic sheets rolled/stacked according to a certain angle with respect to the axis of the filament ("herringbone"structure).

In greater detail, the carbon nanotubes (CNTs) divide into:
- Single-Wall Carbon NanoTubes (SWCNTs), when they consist of a single "graphenic" layer wound on itself so as to form a tubular structure because it is surrounded by a wall;
- Multi-Wall Carbon NanoTubes (MWCNTs), when they are formed from many "graphenic" sheets wound coaxially one on top of the other, as the most simple of the MWCNTs that is the "double walled carbon nanotubes" or DWCNTs, the walls of which consist of two graphenic planes rolled around one another.

The way in which the "graphenic wall" of a nanotube is wound or rolled is represented by two indicators (m,n), which define a chiral vector that determines different types of SWCNTs. The nanotube is called "zigzag" or "armchair", respectively, when m=0 or when m=n, otherwise it is "chiral" (m≠n, m>0). This "fine" division of the single wall carbon nanotubes (SWCNTs) and double walled carbon nanotubes (DWCNTs) is necessary to justify the different electrical behaviour: according to the different "chirality", the CNTs has different electrical characteristics and can be a semi-conductor (bandgap up to ≈2eV) or metallic (bandgap = OeV). For multi-wall carbon nanotubes with n > 2, the electrical behaviour is metallic (Eg=0eV), because it is given by the sum of the contributions of the single walls.

For a given carbon nanotube (n,m), if n = m (armchair) the nanotube is metallic, if n ― m is a multiple of 3 the nanotube is a semi-conductor with a very small bandgap, otherwise the nanotube is moderately semi-conductive. However, this general rule has exceptions, due to the more or less marked curvature that can influence the electrical characteristics.

In theory, the metallic nanotubes can support very high electric current densities ≈10⁹ A/cm² that is a much larger value than that of copper. The electrical conductivity (low resistivity) is also very high.

From scientific literature the electrical behaviour of the carbon nanofibres (CNFs), of the carbon nanotubes (CNTs) and/or of mixed CNFs/CNTs systems is extremely varied and difficult to define because it depends on many factors, in particular how the electrical measurement is carried out (measurement parameters), if the measurement is carried out on a single filament or not and on the nanofilaments' own characteristics (synthesis temperature, type of carbon precursors used, presence of "coating", catalyst residues, impurities and/or "dopants", diameter and length of the nanofilaments, on the consequent degree of crystalline order, on the homogeneity of the sample in terms of distribution of diameters/lengths/phases present CNTs and/or CNFs when the measurement is carried out on systems that contain more than one filament). In addition, due to the presence of defects, diameter, helicity, the finite size of the nanotubes, the temperature, presence of magnetic fields, etc., the experimental values are below the theoretical ones. For example, the following table shows some measured current density and resistivity values for the carbon nanotubes. Said values are compared here with those of other types of materials:

| **material** | **Electrical resistivity** (Ω ·cm) | **Current density** (A/cm⁻²) | **references** |
|---|---|---|---|
| CNTs | 0.8 - 5.1 10⁻⁶ | 6x10⁶ | Nature 382, 1996, 54 |
| SWCNTs | | | Phys. Rev. Lett. 84 (2000)2941 |
| Pressed MWCNTs | (1.2―1.6) × 10⁻² | | Mater. Sci. Eng. A, 420 2006, 208 |
| carbon nanofibres d ≈ 20-80 nm, L>30 µm | ≈10⁻³ | | GANF-I and GANF-III datasheet, from: Grupo Antolin Carbon NanoFibers |
| Crystalline graphite (along the plane) | 3.810⁻⁵ | | Nature 382, 1996, 54 |
| Silver | 1.59×10⁻⁸ | | Griffiths, David (1999) [1981]. "7. Electrodynamics". in Alison Reeves (ed.). |
| Copper | 1.68×10⁻⁸ | | Introduction to Electrodynamics (3rd edition ed.). |

The carbon nanotubes (CNTs) can be considered similar to carbon nitride nanotubes (CNNTs) that can take up the structures of CNTs (armchair, zigzag) where some atoms of N substitute the carbon.

The CNFs and/or CNTs are incorporated in the polymeric matrix in an amount such as to keep the resulting nanocomposite material below the conductivity threshold, typically in an amount from 0.1 to 10% by weight and preferably from 1 to 3% by weight, referring to the nanocomposite material..

The presence of the aforementioned filamentary nanostructures dispersed in the composite material has proven to be of fundamental importance for the formation of conductive traces. Indeed, from comparative tests carried out using just carbon black, in similar amounts to the carbon nanotubes, it has been found that only weakly conductive traces are produced that are not suitable for the purposes of the sought application. As a non-limiting example, it can be considered that the localised heating produced by the laser beam induces a selective surface ablation of the polymeric matrix, making the nanotubes or the carbon nanofibres dispersed in the matrix emerge. Moreover, the interaction of the laser beam with the polymeric substrate promotes its thermal decomposition and the consequent formation of carbon. The carbon formed in this way acts as a bridge between the nanotubes or the nanofibres highlighted by the ablation process, making the traces electrically conductive.

According to the invention, lamellar silicates are used as carbonisation promoters, in combination with the aforementioned carbon nanotubes, said lamellar silicates preferably having an average thickness < 5 nm and maximum thickness <10 nm and belonging to the family of phyllosilicates; preferably phyllosilicates belonging to the family of smetic clay, in particular montmorillonite, hectorite, fluorohectorite, pyrophyllite.

In order to promote the nanoscopic dispersion of the plates of phyllosilicate in the polymeric matrix (exfoliation and/or intercalation) organically modified smetic clays (organoclay) can be used. Such a modification is obtained by ion exchange of the inorganic cations present between the plates, typically ions of alkaline and alkaline-earth metals, with organic ions.

For example, as modifying cations it is possible to use ammonium (^{⊕}NH₃R₁, ^{⊕}NH₂R₁R₂, ^{⊕}NHR₁R₂R₃, ^{⊕}NR₁R₂R₃R₄) or phosphonium (^{⊕}PH₃R₁, ^{⊕}NP₂R₁R₂, ^{⊕}PHR₁R₂R₃, ^{⊕}PR₁R₂R₃R₄).

The lamellar silicates are introduced into the polymeric matrix in an amount from 0.1 to 20% by weight and preferably between 0.5 and 10%, values referred to the weight of the composite material.

The present invention applies in particular to the production of conductive traces in substrates forming or comprising in prevalence non char forming polymers, which term is meant to designate polymers for which the thermal degradation (at a temperature typically over 500°C) leads to the almost complete volatilisation of the polymer.

The polymeric matrix material can thus, preferably, be thermoplastic polymers that are notoriously known for the low efficiency in producing carbonaceous materials; in particular, polyolefin polymers and copolymers are preferred, including polyethylenes (including UHMWPE, HMWPE, HDPE, MDPE, MLDPE, LDPE), polypropylene, ethylene-propylene copolymers, styrene polymers (PS), ethylene copolymers including polyethylene-vinylacetate (EVA) and acrylic polymers, including in particular polyacrylates, polymethacrylates and polymethylmethacrylates.

The polymeric material can also comprise a mixture of two or more of the polymers quoted above.

Also covered by the invention is the use of polymeric materials, such as the polymers and copolymers quoted above, including compatibilising copolymers, particularly compatibilising copolymers with regard to the added lamellar silicates. As compatibilisers - the olefin polymers - with regard to the phyllosilicates we quote for example copolymers of polyethylene maleate (MA-g-PE) and polypropylene maleate (MA-g-PP), as well as poly(ethylene-co-vinylacetate).

For the writing of the traces by laser, it is possible to use any laser source operated in a continuous, modulated or pulsed manner (provided that it is with prevalently thermal interaction) and with a wavelength such as to interact with the polymeric matrix and/or with the additives added as carbonisation promoters.

Both sources with emission in the near infrared or in the visible, and laser sources with emission in the far infrared are suitable for the purpose. Whereas the second ones interact directly with the polymer, pyrolysing it and thus inducing the carbonisation decomposing it, the first ones do not interact directly with the polymeric matrix but with the nanotubes, which by heating up give up heat to the polymer that thus decomposes. In both cases the effect of the laser translates into an increase in the local density of the nanotubes in the laser treated area, which leads to an increase in conductivity through the percolation limit being exceeded. The laser treatment in object is characterised precisely by this effect of increase in local density of the nanotubes, without having negative effects of damaging or destroying the nanotubes themselves due to the use of peak powers that are too high (typical for example of Q-switched laser sources).

The laser sources that can be used in the process are, preferably:
- laser Nd:YAG (also as disk-laser) or Nd:YLF or Nd:YVO4 or Nd:glass with emission wavelength in the near IR at about 1 micron, with average power of between 5 and 500 W, in continuous or pulsed operating condition. It should be noted that the use of Q-switched sources, with pulses lasting 5-500 ns, although capable of giving negative variations of resistivity, nevertheless are not the most suitable since the high peak powers reached lead to the nanotubes being damaged. On the other hand, the use of laser with continuous emission is optimal since the interaction leads to the pyrolysis of the polymeric material without damaging the nanotubes; however even the use of neodymium-based laser pulsed in free running condition, or else modulated, or else in Q-switch condition at high frequency (f >20 kHz) leads to appreciable increases of the conductivity of the treated areas.
- CO2 laser, having wavelengths of between 9 and 11 micron, with average power between 5 and 1000 W, in continuous, pulsed or modulated operating condition.
- diode laser of wavelength between 0.5 and 3 micron, with average power between 5 and 1000 W, in continuous, pulsed or modulated operating condition.
- fiber laser, of the Ytterbium fiber laser type with emission at about 1 micron, with average power between 5 and 1000 W, in continuous, pulsed or modulated operating condition. For the pulsed sources in Q-switched condition the same observations already made for Nd:YAG laser are applied.

In the preferred embodiment, the laser irradiation laser is carried out by applying a specific energy per unit length (dimensionally corresponding to Energy per unit volume) of between 0.1 and 10 Joule/mm³, applicable to all of the wavelengths considered (UV-FIR).

In the case of laser operation in pulsed condition, the peak power applied (expressed as laser pulse energy referring to the duration of the pulse per unit area) is preferably not greater than 15 MWatt/cm².

In the case of continuous laser operation, the peak power corresponds to the average power applied and is preferably between 5-Watt/cm² and 10MW/cm².

The traces are written on the polymeric substrate at a speed of from 5 mm/s up to 20 m/s. The speed depends on the power of the laser used: the greater the power, the greater the speed that can be used. The commercially available sources easily reach hundreds of Watts of power in principle allowing the process to be carried out at speeds of many tens of metres per minute.

The laser spot can be configured in a round shape, or else elongated like a blade.

The trace can be written with a single pass that uses a laser spot of diameter (or width) equal to the width of the trace, or else with many passes alongside one another to generate a trace of greater width with respect to the diameter of the laser spot, or else with many passes on top of one another. By using scanning systems, it is also possible to use the "wobble" function, which puts a spiral movement over the top of the linear motion, for which reason the width of the trace generated depends on the diameter of the spiral.

The writing can take place at atmospheric pressure in the presence of air or of a flow of inert gas (typically nitrogen, but also argon and helium) directed onto the interaction area, so as to limit the presence of oxygen that could promote the combustion of the polymeric substrate. Covering with inert gas improves the process, but it is not essential. A further possibility is the use of a closed processing chamber with inert gas atmosphere, with pressures of between 0.1 atm and 5 atm.

Further characteristics and advantages of the process according to the invention will become clear from the following description and from the embodiments, correlated to the attached drawings in which:
- figure 1 is a schematic illustration that illustrates three possible direct laser writing configurations, including:
   1) movement of the sample;
   2a) movement of the head;
   2b) movement of the laser beam through a scanning head with galvanometric mirrors;
- figure 2 is a schematic illustration of a laser scanning head;

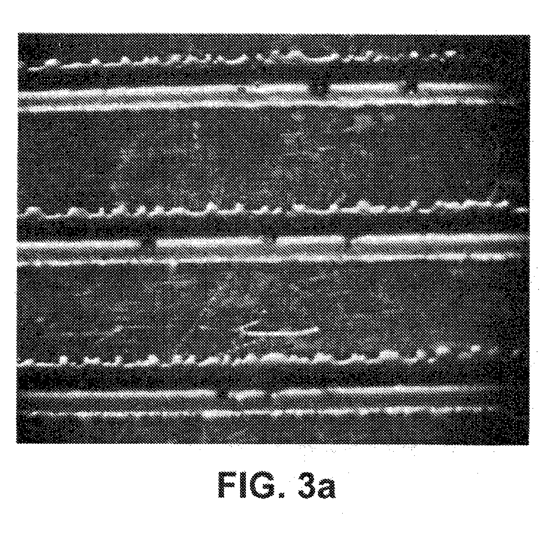

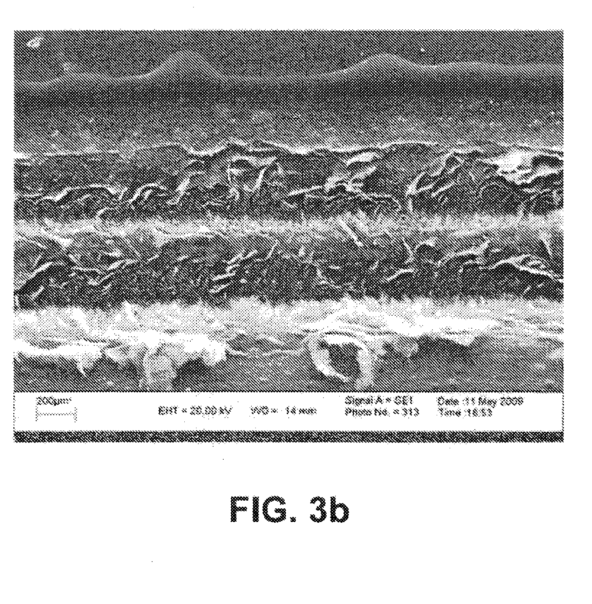

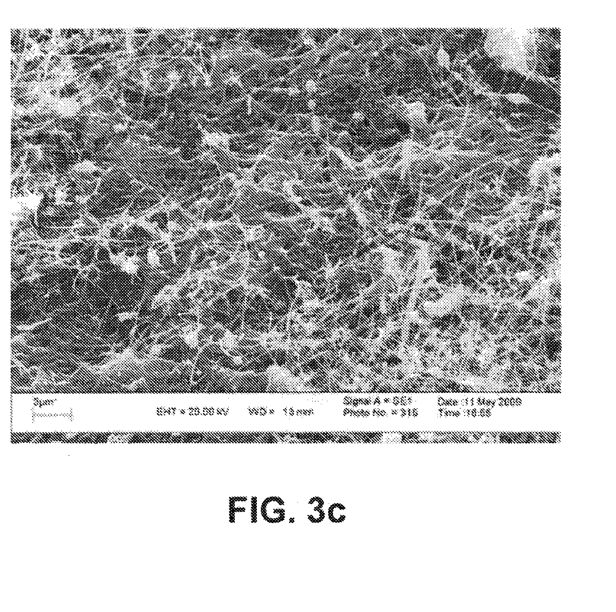

- figures 3a, 3b and 3c are electron microscope photographs of the conductive traces obtained;
- figure 4 illustrates the resistivity graphs as a function of the writing speed for various concentrations of CNTs.

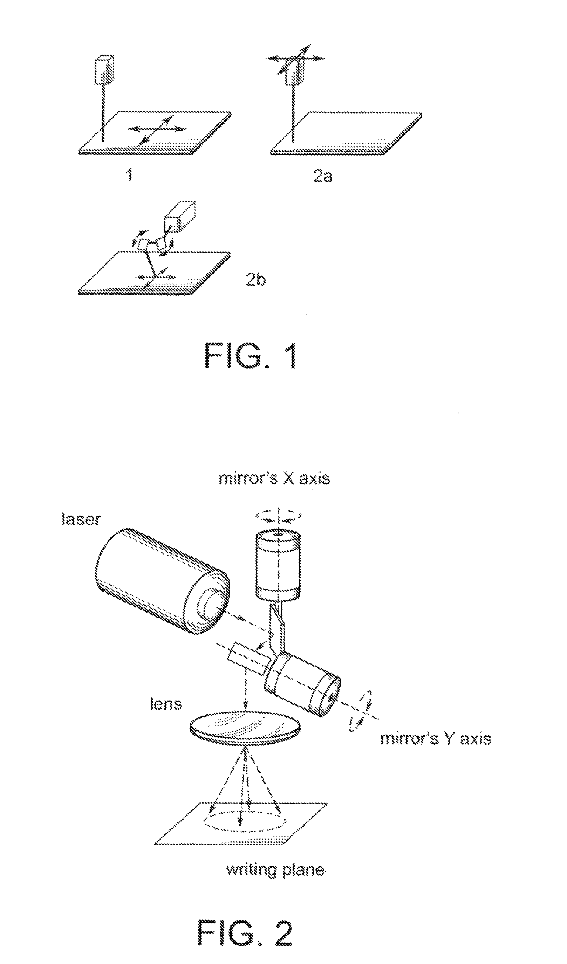

With reference to the drawings, in order to detect the traces, whatever source is used, the following configurations can be foreseen:
1. movement of the sample through motorised axles (figure 1-1), whereas the laser beam, suitably focussed, stays fixed: according to the configuration of the axles and the types of motors, it is possible to achieve a movement in space with up to 5 degrees of freedom (thus also to make three-dimensional tracks, with a speed of up to 500 m/min);
2. movement of the laser beam:
   a) through a system of motorised axles that move the focussing laser head (figure 1-2a), consequently moving the laser beam over the surface of the sample; systems and performance are analogous to the case in which the sample is moved;
   b) through a scanning head with galvanometric mirrors (figure 1-2b): the laser beam is moved over the plane (with heads equipped with normal F-theta lenses or telecentric lenses) or in space (using Z-dynamic scanning heads), with speeds that can reach 50 m/min.
3. movement both of the beam, and of the sample, with a hybrid configuration between 1 and 2a, distributing the degrees of freedom on the first or on the second, as most convenient based on the geometries.

The tracks made have the characteristics that allow signals in general to be transmitted, at frequencies that are not too high, proportionally to the length of the conductive track and consequently to its impedance. Moreover, they can support the power supply of circuits of limited size.

With these conductive tracks it is thus possible for example to transmit signals useful for making sensor be controlled remotely. For the power supplies, on the other hand, they can be transported over circuits of the order of a few square centimetres or over larger areas, in the case in which the circuits are Low Power.

The resistivity values of the conductive traces that can be obtained through the process according to the invention depend on different factors, including the nature of the matrix polymer and of the additives, on the content of the carbonisation promoter, on the conditions and the application parameters of the laser irradiation, presence of inert atmosphere, air or other.

### Example 1

### Materials

In this example the nanocomposites are prepared from granules of polyethylene (PE) or polypropylene (PP) with which a percentage by weight of CNTs (from 1 to 3%) of industrial origin (MITSUI) is mixed at hot temperature. The matrix of polyethylene loaded with CNTs is also added to with 5% organically modified sodium montmorillonite (Na-OMMT) and 5% poly(ethylene-co-vinylacetate) (EVA), containing 19% by weight of vinylacetate. The polypropylene-based matrices are, on the other hand, added to with 5% by weight of polypropylene maleate (MA-g-PP), containing 1 % by weight of maleic anhydride. EVA and MA-g-PP are used as compatibilizers for the montmorillonite. For mixing a melt-mixer (Brabender) is used. The temperature in the mixing chamber is kept at 170-180°C and the mixing time is limited to 5 min, to avoid the oxidation of the nanocomposite obtained, which is extracted from the mixing chamber and reduced into sheets of about 1 mm in thickness using a press heated to 175-195°C and a load of about 20 bar.

### Laser treatment

The laser source used is an Nd:YAG, Q-switched (model Extreme E200 Quanta System) having a wavelength of 1.06 micron and a power of between 0 - 170 W. The repetition frequency of the source is between 7-60 kHz or else it can be operated in continuous emission (cw). The system for moving the laser beam consists of a scanning head with aperture 15 mm with a focal lens having plane field with a 250 mm focal.

In this example, the laser source operates in continuous emission at a power of 11 Watts. The laser treatment takes place under a flow of nitrogen gas. The traces, 10 mm long and spaced apart by 1.5 mm, are made at different scanning speeds of the laser beam and with two different widths: 0.6 and 1.2 mm.

### Results

In order to carry out the impedance measurements two instruments were used: the impedance analyser HP 4192A (with high full scale 2 MΩ) for frequency analysis and the Tektronix multimeter DM 5120 (with high full scale 300 MΩ) for continuous analysis.

As electrodes for measurement two tungsten filaments were used, suitably bent to allow a good contact with the trace to be analysed. The electrodes thus formed were positioned on the samples through micromanipulators and the distance between the contacts is about 9 mm.

The resistivity decreases as the writing speed (i.e. the irradiation time) decreases and as the width of the traces increases. The conductivity is also directly proportional to the percentage of nanotubes, but the process shows a saturation effect for concentrations over 2%, which represents the percolation threshold for polyethylene and polypropylene.
- Polyethylene-based nanocomposite:
   The resistivity values measured at the end of the traces obtained, with the method described above, are about 100-200 kΩ·cm for traces 0.6 mm wide and written at 25 mm/s on nanocomposites containing 1% CNTs and they fall to 10-20 kΩ·cm for concentrations of nanotubes of 2-3%.
      For traces 1.2 mm wide and written at 8 mm/s, the minimum resistivity values obtained are 11 kΩ·cm for concentrations of CNTs of 1% and 0.6-0.7 kΩ·cm for concentrations of 2-3%.
- Polypropylene-based nanocomposite:
   The resistivity values measured at the end of the traces obtained, with the method described above, are about 3 kΩ·cm for traces written at 13 mm/s on nanocomposites containing 1% CNTs and they fall to 0.5-0.9 kΩ·cm for concentrations of nanotubes of 2-3%. The conductivity values are similar both for the traces 0.6 mm wide and for those that are 1.2 mm wide.

### Example 2: CO₂ laser source

### Materials

The nanocomposites and preparation methods are analogous to example 1.

### Laser treatment

The source used is a CO₂ laser with slow catalysed coaxial flow (model: EI-En Blade 1500) of wavelength: 10.6 µm and power of between 100 and 1500 Watts. The source can be operated in modulated or continuous emission.

In this example the traces are made in continuous emission operating condition at an actual power on the sample of 32 Watts. The movement system consists of a chuck rotating with a plate on which the sample has been fixed; a square metallic mask and a focal lens make it possible to select the size of the spot and the laser power hitting the sample. A more inert atmosphere is obtained with a nozzle and a nitrogen flow.

### Results

The conductivity measurements were made in an analogous way to example 1.
- Polyethylene-based nanocomposite:
   The resistivity values measured at the end of the traces obtained, with the method described above, are about 1.6 kΩ·cm for traces 1.2 mm wide and written at 9 mm/s on nanocomposites containing 1% CNTs and they fall to 1.3-0.9 kΩ·cm for concentrations of nanotubes of 2-3%.
- Polypropylene-based nanocomposite:
   The resistivity values reach about 0.15 kΩ·cm for traces written at 9 mm/s.

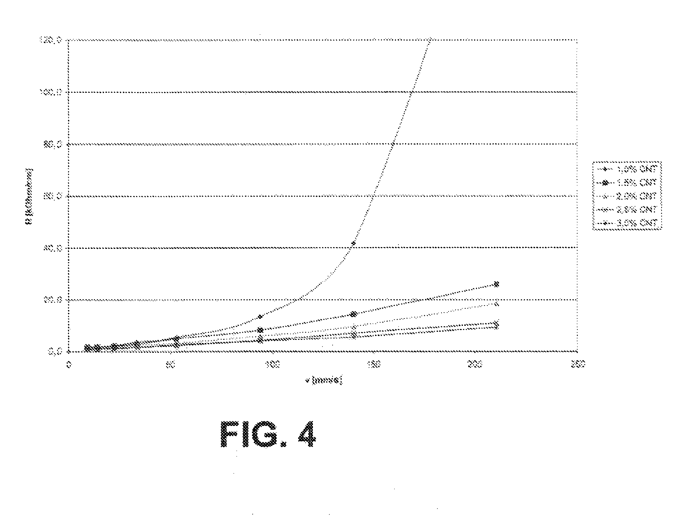

Figure 4 illustrates the resistivity graphs as a function of the writing speed for various concentrations of CNTs with reference to example 2.

It is meant for the process according to the invention to be able to be applied to substrates consisting of the composite polymeric material in mass, as well as to substrates having a surface layer formed from the aforementioned composite polymeric material.

The conductivity values achieved after laser ablation allow the application of the process of the invention, to make electrical connections even substituting copper connections, which are expensive and difficult to recycle. The traces, created according to paths that can be modified as desired, can be used to make simple electric devices (such as buttons, sensors, antennae, etc.) incorporated in polymers widely used in automobiles and in domestic appliances.

Thanks to the special properties with which the CNTs are equipped, their use as filler in polymeric matrices commonly used to make components in the automobile industry makes it possible to give the composite material special electrical properties. In particular, the addition of CNTs or CNFs, even in a very low percentage with respect to conventional fillers, provides high electrical conductivity values and, moreover, in certain doses, is able to give piezoresistive properties to the composite, such as to make it sensitive to the presence of external deformation and pressure stimuli. It is thus possible to provide polymers capable of recognising different types of contact (a simple brushing, a slight pressure or impact) thus actually making a "touch sensitive integrating switch" material.

The proportionality between the variation of the electrical properties of the composite and the force exerted can also allow distributed pressure sensors to be made. In particular, with suitable laser treatments on the composites, it is possible to create the CNTs inside the matrix, just in the areas hit by the laser beam, thus obtaining area with high concentration of CNTs. It is also possible to make, directly on the polymeric matrix, distinct conductive traces and piezoresistive areas, thus making surfaces equipped with internal electric circuits for the transportation of signals and with sensitive active areas having a button function.

## Claims

1. Process for producing electrically conductive and/or piezoresistive traces in a non-conductive polymeric substrate through laser irradiation, wherein said substrate is a composite polymeric material, comprising a matrix comprising a non char forming polymer and a dispersed phase comprising carbon or carbon nitride nanotubes or carbon nanofibres, **characterised in that** said composite material also comprises particles of a lamellar silicate in a quantity from 0.1 to 20% by weight, referred to the weight of the composite material.

2. Process according to claim 1, **characterised in that** said polymeric material of the matrix comprises an olefinic polymer, un olefinic copolymer, a copolymer of ethylene, an acrylic polymer or their mixtures.

3. Process according to claim 2, **characterised in that** said matrix polymeric material comprises a polyethylene, a polypropylene, a polystyrene, ethylene-propylene copolymers, polyethylene-vinylacetate, polymethylmethacrylate and their mixtures.

4. Process according to any one of claims 1 to 3, **characterised in that** said composite material comprises carbon nano fibres and/or carbon nanotubes in a quantity from 0.1 to 10% by weight, referred to the composite material.

5. Process according to any one of claims 1 to 4, **characterised in that** said lamellar silicate is functionalised with organophilic functionalities.

6. Process according to claim 5, **characterised in that** said lamellar silicate is in a quantity from 0.5 to 10% by weight, referring to the weight of the composite material.

7. Process according to any one of claims 1 to 6, **characterised in that** said lamellar silicate is selected from the group consisting of montmorillonite, hectorite, fluorohectorite and pyrophyllite.

8. Process according to claims 5 or 6, **characterised in that** said matrix polymeric material also comprises a compatibilizing polymer selected among polyethylene maleate (MA-g-PE), polypropylene maleate (MA-g-PP) and poly(ethylene-co-vinylacetate).

9. Process according to any one of the previous claims, **characterised in that** the irradiation by laser is carried out through a Nd:YAG, Nd:YLF, Nd:YVO4, Nd:glass laser source, CO₂ laser, diode laser source and fibre laser.

10. Process according to any one of the previous claims, **characterised in that** the laser irradiation is carried out by applying a specific energy per unit length of between 0.1 and 10 Joule/mm³_{.}

11. Process according to any one of the previous claims, **characterised in that** the laser irradiation is carried out with continuous laser emission with a specific power of over 5 Watt/cm².

12. Process according to any one of claims 1 to 10, **characterised in that** the laser irradiation is carried out with pulsed emission with a specific power of no more than 15 MWatt/cm².

## Patentansprüche

1. Verfahren zur Erzeugung elektrisch leitender und/oder piezoresistiver Spuren in einem nicht-leitenden Polymersubstrat durch Laserbestrahlung, wobei das Substrat ein Verbundpolymermaterial ist, umfassend eine Matrix umfassend ein keine Kohle bildendes Polymer und eine dispergierte Phase umfassend Kohlenstoff oder Kohlenstroffnitrid-Nanotubes oder Kohlenstoff-Nanofasern, **dadurch gekennzeichnet, dass** das Verbundma-terial Partikel aus laminarem Silikat in einer Menge von 0,1 bis 20 Gew.-% umfasst, bezogen auf das Gewicht des Verbundmaterials.

2. Verfahren nach Anspruch 1, **dadurch gekennzeichnet, dass** das Polymermaterial der Matrix ein olefinisches Polymer, eine olefinisches Copolymer, ein Copolymer von Ethylen, ein Acrylpolymer oder deren Mischungen umfasst.

3. Verfahren nach Anspruch 2, **dadurch gekennzeichnet, dass** das polymere Matrixmaterial ein Polyethylen, ein Polypropylen, ein Polystyrol, Ethyl-Propylen-Copolymere, EthylenVinylacetat, Polymethylmethacrylat und deren Mischungen umfasst.

4. Verfahren nach einem der Ansprüche 1 bis 3, **dadurch gekennzeichnet, dass** das Verbundmaterial Kohlenstoff-Nanofasern und/oder Kohlenstoff-Nanotubes in einer Menge von 0,1 bis 10 Gew.-% umfasst, bezogen auf das Verbundmaterial.

5. Verfahren nach einem der Ansprüche 1 bis 4, **dadurch gekennzeichnet, dass** das laminare Silikat mit organophilen Funktionalitäten funktionalisiert ist.

6. Verfahren nach Anspruch 5, **dadurch gekennzeichnet, dass** das laminare Silikat in einer Menge von 0,5 bis 10 Gew.-% in Bezug auf das Gewicht des Verbundmaterials vorhanden ist.

7. Verfahren nach einem der Ansprüche 1 bis 6, **dadurch gekennzeichnet, dass** das laminare Silikat gewählt ist aus der Gruppe bestehend aus Montmorillonit, Hectorit, Fluorohectorit und Pyrophyllit.

8. Verfahren nach Anspruch 5 oder 6, **dadurch gekennzeichnet, dass** das polymere Matrixmaterial ein kompatibilisierendes Polymer umfasst, gewählt aus Polyethylenmaleat (MA-g-PE), Polypropylenmaleat (MA-g-PP) und Poly(ethylen-Co-Vinylacetat).

9. Verfahren nach einem der vorangehenden Ansprüche, **dadurch gekennzeichnet, dass** die Bestrahlung durch den Laser durch eine Nd:YAG, Nd:YLF, Nd:YVO4, Nd:Glaslaserquelle, CO₂-Laser Diodenlaserquelle und Faserlaser durchgeführt wird.

10. Verfahren nach einem der vorangehenden Ansprüche, **dadurch gekennzeichnet, dass** die Laserbestrahlung durchgeführt wird, indem eine spezifische Energie je Einheitslänge von zwischen 0,1 bis 10 Joule/mm³ angelegt wird.

11. Verfahren nach einem der vorangehenden Ansprüche, **dadurch gekennzeichnet, dass** die Laserbestrahlung mit einer kontinuierlichen Laseremission mit einer spezifischen Leistung von über 5 W/cm² durchgeführt wird.

12. Verfahren nach einem der Ansprüche 1 bis 10, **dadurch gekennzeichnet, dass** die Laserbestrahlung mit gepulster Emission mit einer spezifischen Leistung von nicht mehr als 15 MW/cm² durchgeführt wird.

## Revendications

1. Procédé pour produire des pistes électriquement conductrices et/ou piézorésistives dans un substrat polymère non conducteur par le biais d'une irradiation laser, dans lequel ledit substrat est un matériau polymère composite, comprenant une matrice comprenant un polymère ne charbonnant pas et une phase dispersée comprenant des nanotubes de carbone ou de nitrure de carbone ou des nanofibres de carbone, **caractérisé en ce que** ledit matériau composite comprend aussi des particules d'un silicate lamellaire en une quantité de 0,1 à 20 % en poids par rapport au poids du matériau composite.

2. Procédé selon la revendication 1, **caractérisé en ce que** ledit matériau polymère de la matrice comprend un polymère oléfinique, un copolymère oléfinique, un copolymère d'éthylène, un polymère acrylique ou leurs mélanges.

3. Procédé selon la revendication 2, **caractérisé en ce que** ledit matériau polymère de matrice comprend un polyéthylène, un polypropylène, un polystyrène, un copolymère d'éthylène-propylène, le poly(éthylène-acétate de vinyle), le poly(méthacrylate de méthyle), et leurs mélanges.

4. Procédé selon l'une quelconque des revendications 1 à 3, **caractérisé en ce que** ledit matériau composite comprend des nanofibres de carbone et/ou des nanotubes de carbone en une quantité de 0,1 à 10 % en poids par rapport au matériau composite.

5. Procédé selon l'une quelconque des revendications 1 à 4, **caractérisé en ce que** ledit silicate lamellaire est fonctionnalisé avec des fonctionnalités organophiles.

6. Procédé selon la revendication 5, **caractérisé en ce que** ledit silicate lamellaire est présent en une quantité de 0,5 à 10 % en poids par rapport au poids du matériau composite.

7. Procédé selon l'une quelconque des revendications 1 à 6, **caractérisé en ce que** ledit silicate lamellaire est choisi dans le groupe constitué par la montmorillonite, l'hectorite, la fluorohectorite et la pyrophyllite.

8. Procédé selon la revendication 5 ou 6, **caractérisé en ce que** ledit matériau polymère de matrice comprend un polymère de compatibilité choisi parmi le poly(maléate d'éthylène) (MA-g-PE), le poly(maléate de propylène) (MA-g-PP) et le copoly(éthylène-acétate de vinyle).

9. Procédé selon l'une quelconque des revendications précédentes, **caractérisé en ce que** l'irradiation laser est effectuée au moyen d'une source de laser Nd:YAG, Nd:YLF, Nd:YV04, Nd:verre, d'un laser à CO2, d'une source de laser à diode et d'un laser à fibres.

10. Procédé selon l'une quelconque des revendications précédentes, **caractérisé en ce que** l'irradiation laser est effectuée par application d'une énergie spécifique par unité de longueur comprise entre 0,1 et 10 Joules/mm³.

11. Procédé selon l'une quelconque des revendications précédentes, **caractérisé en ce que** l'irradiation laser est effectuée par une émission de laser continue avec une puissance spécifique supérieure à 5 Watts/cm².

12. Procédé selon l'une quelconque des revendications 1 à 10, **caractérisé en ce que** l'irradiation laser est effectuée par une émission pulsée avec une puissance spécifique ne dépassant pas 15 MWatts/cm².
